# EUROPEAN PATENT APPLICATION

(11) **EP 1 995 870 A1**
(43) Date of publication of application: **26.11.2008**
(21) Application number: 07737874.3
(22) Date of filing: 06.03.2007
(51) Int. Cl.: H02P 27/06, H02M 7/48

(54) **EARTH-FAULT DETECTING METHOD**

(30) Priority: 09.03.2006 JP 2006063648
(71) Applicant: Daikin Industries, Ltd., Osaka-shi, Osaka 5308323 (JP)
(72) Inventor: YAGI, Satoshi, Sakai-shi, Osaka 591-8511 (JP); KOKURA, Takeshi, Kadoma-shi, Osaka 571-0032 (JP); NOMURA, Shinichirou, Sakai-shi, Osaka 591-8511 (JP); YOSHISAKA, Keiichi, Sakai-shi, Osaka 591-8511 (JP)
(74) Representative: HOFFMANN EITLE
(86) International application number: PCT/JP2007/054327
(87) International publication number: WO 2007/102503

(57) **Abstract**

The present invention is intended for a ground fault detection method of detecting a ground fault generated in a motor using an existing inverter. When a ground fault is generated in a three-phase motor (10), each time any one of high arm side transistors (Q21 to Q23) and low arm side transistors (Q24 to Q26) constituting an inverter circuit (20) is switched from ON to OFF, a voltage across a smoothing capacitor 1 rises. The voltage across the smoothing capacitor (1) is detected at a ground fault detection part (3), and an increment within a first certain period of time and an increment within a second certain period of time are calculated. As a result, a ground fault can be detected independently of sudden power failure.

## Description

### TECHNICAL FIELD

The present invention relates to a ground fault detection method, and more specifically, to an inverter for driving a polyphase motor.

### BACKGROUND ART

With regard to motor driving devices for driving motors, patent publication 1 discloses a motor driving device capable of specifying a location at which electrical leakage is generated. In the motor driving device disclosed in patent publication 1, an AC power supply is connected through a CR series circuit to a negative bus. Electrical leakage is detected based on the amplitude of an AC waveform at a node between resistors and a capacitor of the CR series circuit.

Patent Publication 1: Japanese Patent Application Laid-Open No. 2005-304138 DISCLOSURE OF THE INVENTION

### PROBLEMS TO BE SOLVED BY THE INVENTION

However, the motor driving device disclosed in patent publication 1 requires an AC power supply and a CR series circuit dedicated to the detection of electrical leakage. This causes problems of the increase of circuit scale and the increase in manufacturing costs.

Hence, the present invention is intended to provide a technique of detecting a ground fault generated in a motor using an existing device without adding another circuit dedicated to the detection of electrical leakage.

### MEANS FOR SOLVING PROBLEMS

A first aspect of a ground fault detection method of the present invention is intended for a ground fault detection method of detecting a ground fault generated in an inductive polyphase load (10) driven by an inverter (100). The inverter comprises: a first DC power line (VH); a second DC power line (VL) to which a potential is applied that is lower than a potential applied to the first DC power line; a smoothing capacitor (1) connected between the first DC power line and the second DC power line; a plurality of output lines (L4, L5, L6) connected to the inductive polyphase load; a plurality of high arm side switches (Q21, Q22, Q23) each connected between the first DC power line and a corresponding one of the output lines; diodes (D21, D22, D23) each connected in parallel with a corresponding one of the high arm side switches and having cathodes connected to the first DC power line; a plurality of low arm side switches (Q24, Q25, Q26) each connected between the second DC power line and a corresponding one of the output lines; and diodes (D24, D25, D26) each connected in parallel with a corresponding one of the low arm side switches and having anodes connected to the second DC power line. A voltage across the smoothing capacitor rises by the switching of at least any one of the high arm side switches and the low arm side switches from ON to OFF, thereby determining that the ground fault is generated.

A second aspect of the ground fault detection method of the present invention executes, in the ground fault detection method of the first aspect, (a) a step (S1) of detecting a first one of the voltage (Vt1) across the smoothing capacitor; (b) a step (S2) of detecting a second one of the voltage (Vt2) across the smoothing capacitor after at least any one of the high arm side switches and the low arm side switches is switched from ON to OFF from the time of the execution of the step (a); and (c) a step (S3, S4) of determining whether or not an increment (ΔV1) of the second one of the voltage relative to the first one of the voltage exceeds a first certain value.

A third aspect of the ground fault detection method of the present invention further executes, in the ground fault detection method of the second aspect, (d) a step (S5) of detecting a third one of the voltage (Vt3) across the smoothing capacitor after at least any one of the high arm side switches and the low arm side switches is switched from ON to OFF from the time of the execution of the step (b); and (e) a step (S6, S7) of determining whether or not an increment (ΔV2) of the third one of the voltage relative to the second one of the voltage exceeds a second certain value.

### EFFECT OF THE INVENTION

According to the first aspect of the ground fault detection method of the present invention, a ground fault generated in an inductive polyphase load can be detected using an existing device without adding another circuit dedicated to ground fault detection.

According to the second aspect of the ground fault detection method of the present invention, the voltage is judged to have risen when the increment has exceeded the first certain value.

According to the third aspect of the ground fault detection method of the present invention, the voltage is judged to have risen when each of the two increments has exceeded a corresponding one of the first and second certain values. Thus, a ground fault can be detected independently of power failure.

These and other objects, features, aspects and advantages will become more apparent from the following detailed description of the present invention when taken in conjunction with the accompanying drawings.

### Brief Description of Drawings

Fig. 1 is a view of the schematic configuration of an inverter system according to an embodiment;
Fig. 2 is a view showing a voltage Vdc across a smoothing capacitor when a ground fault is generated;
Fig. 3 is a view showing the mechanism of the rise of the voltage Vdc across the smoothing capacitor when a ground fault is generated; and
Fig. 4 shows operations of ground fault detection in the inverter system according to the embodiment.

### BEST MODE FOR CARRYING OUT THE INVENTION

### Embodiment

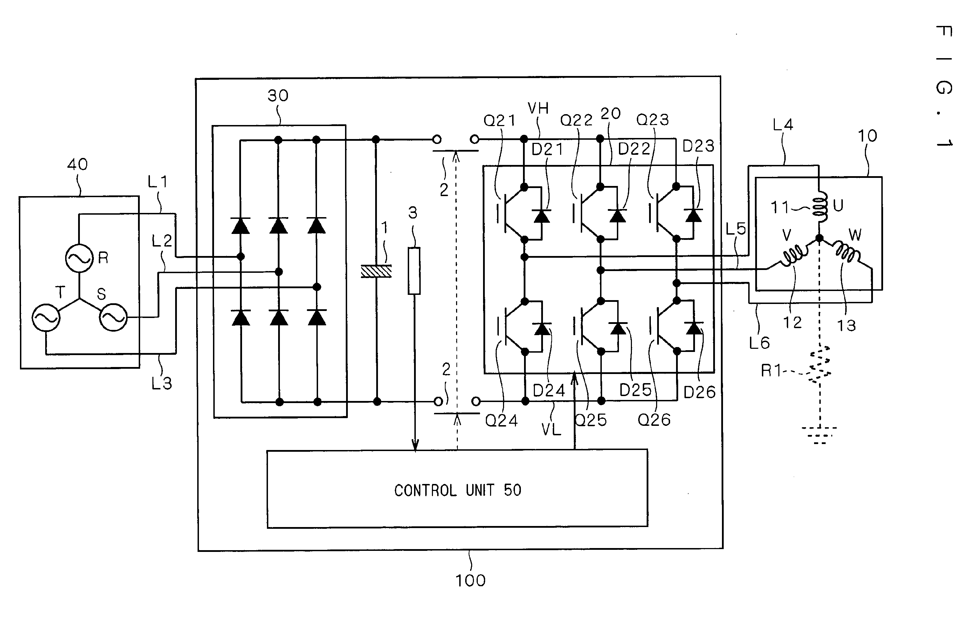

Fig. 1 is a view schematically showing the configuration of an inverter system that realizes a technique of detecting a ground fault according to the present invention. An inverter 100 receives power from a three-phase AC power supply 40 to drive a three-phase motor 10.

The three-phase motor 10 includes a coil 11 of U phase, a coil 12 of V phase and a coil 13 of W phase, and is driven by receiving a three-phase voltage supplied from the inverter 100.

The inverter 100 includes input lines L1 to L3, output lines L4 to L6, a first DC power line VH, a second DC power line VL to which a potential is applied that is lower than a potential applied to the first DC power line VH, a rectifier circuit 30, a smoothing capacitor 1, switches 2, a voltage detection part 3, an inverter circuit 20 and a control unit 50.

The rectifier circuit 30 includes parallel-connected three pairs of two diodes that are connected in series between the first DC power line VH and the second DC power line VL with cathodes directed toward the first DC power line VH. Nodes of the series-connected two diodes are connected to one ends of R, S and T phases of the three-phase AC power supply 40 through the input lines L1 to L3, respectively. The rectifier circuit 30 rectifies an alternating current from the three-phase AC power supply 40.

The smoothing capacitor 1 is connected between the first DC power line VH and the second DC power line VL, and smoothes a DC voltage rectified by the rectifier circuit 30.

The inverter circuit 20 includes high arm side transistors Q21 to Q23 each connected between the first DC power line VH and a corresponding one of the output lines L4 to L6, diodes D21 to D23 each connected in parallel with a corresponding one of the high arm side transistors Q21 to Q23 and having cathodes connected to the first DC power line VH, low arm side transistors Q24 to Q26 each connected between the second DC power line VL and a corresponding one of the output lines L4 to L6, and diodes D24 to D26 each connected in parallel with a corresponding one of the low arm side transistors Q24 to Q26 and having anodes connected to the second DC power line VL.

The output lines L4 to L6 are connected respectively to one ends of the coil 11 of U phase, the coil 12 of V phase and the coil 12 of W phase that constitute the three-phase motor 10. The inverter circuit 20 converts a DC voltage supplied from the smoothing capacitor 1 to an AC voltage based on a PWM (pulse width modulation) signal given from the control unit 50, and supplies the converted AC voltage to the three-phase motor 10 through the output lines L4 to L6, thereby driving the three-phase motor 10.

The voltage detection part 3 detects a voltage Vdc across the smoothing capacitor 1, and outputs the detected voltage Vdc to the control unit 50.

The switches 2 are interposed in the first DC power line VH and the second DC power line VL, and serve as switches for electrically interrupting the first DC power line VH and the second DC power line VL. The switches 2 are controlled by the control unit 50.

In the present embodiment, a ground fault generated in the three-phase motor 10 is detected using the voltage Vdc across the smoothing capacitor 1 detected by the voltage detection part 3 as discussed later. The voltage detection part 3 is not dedicated to the detection of a ground fault. The control unit 50 generally calculates a voltage to be applied to each phase of the three-phase motor 10 based on a current value flowing through the three-phase motor 10, the voltage Vdc across the smoothing capacitor 1 and the like. Based on the result of calculation, the control unit 50 generates and outputs- a PWM signal for controlling ON/OFF of each of the high arm side transistors Q21 to Q23, and each of the low arm side transistors Q24 to Q26 which constitutes the inverter circuit 20. That is, the voltage detection part 3 is inherently provided to drive the three-phase motor 10. Thus, a ground fault generated in an inductive polyphase load can be detected merely by the change of software.

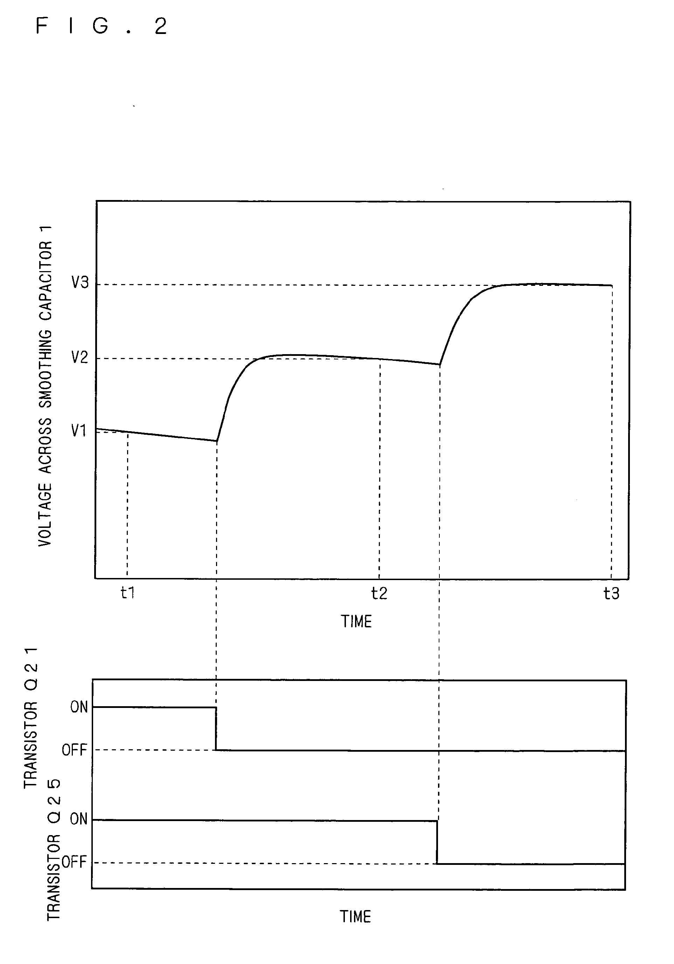

Fig. 2 shows the switching operations of the high arm side transistor and the low arm side transistor and the variations of the voltage Vdc across the smoothing capacitor 1 when a ground fault is generated in the three-phase motor 10. As shown in Fig. 2, when a ground fault is generated in the three-phase motor 10, the high arm side transistor Q21 and the low arm side transistor Q25 are switched from ON to OFF to cause the voltage Vdc across the smoothing capacitor 1 to rise. The mechanism of this operation is discussed in detail below.

As an example, in the inverter system shown in Fig. 1, it is assumed that a ground fault is generated in the three-phase motor 10 by the contact of a neutral point in the three-phase motor 10 with a device casing. At this time, as indicated by dashed lines in Fig. 1, the neutral point in the three-phase motor 10 is regarded as being in contact with a ground resistor R1 when viewed from the three-phase AC power supply 40. The ground resistor R1 has a resistance value of about a few tens to 100 Ω.

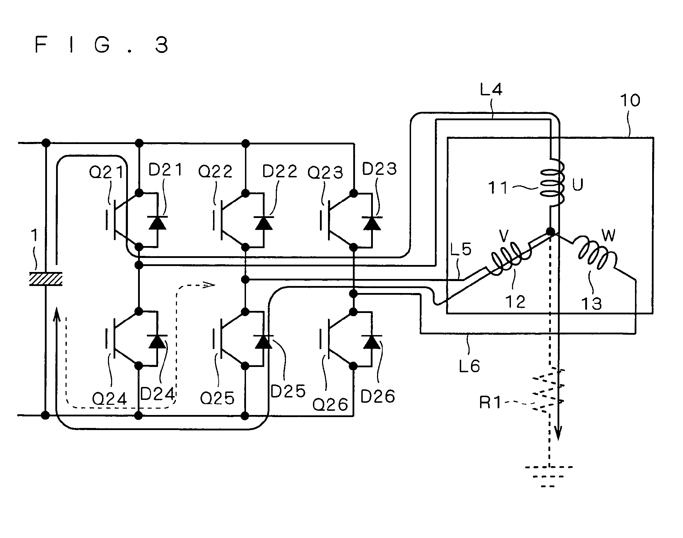

Fig. 3 is a view showing the mechanism of the rise of the voltage Vdc across the smoothing capacitor 1 at the time of the generation of a ground fault. When the high arm side transistor Q21 and the low arm side transistor Q25 are ON, as indicated by solid lines with arrow tips in Fig. 3, a direct current from the smoothing capacitor 1 flows through the high arm side transistor Q21, the output line L4 and the coil 11 of U phase in this order, and is then divided at the neutral point. One part of the current flows into the ground resistor R1, while other part flows through the coil 12 of V phase, the output line L5 and the low arm side transistor Q25 in this order, thereafter flowing into the smoothing capacitor 1.

When the high arm side transistor Q21 is switched from ON to OFF, and when the high arm side transistor Q23 given as an example is switched from OFF to ON, the coil 11 of U phase generates a counter electromotive force by self inductance thereof. This generates a current flowing through the diode D24, the output line L4 and the coil 11 of U phase in this order, thereafter flowing into the ground resistor R1 as indicated by a dashed line with an arrow tip shown in Fig. 3. Thus, electric charges are accumulated in the smoothing capacitor 1 to raise the voltage Vdc across the smoothing capacitor 1 as shown in Fig. 2.

Likewise, when the low arm side transistor Q25 is switched from ON to OFF, and when the low arm side transistor Q24 given as an example is switched from OFF to ON, the coil 12 of V phase generates a counter electromotive force by self inductance thereof. As a result, a current is caused to flow through the ground resistor R1, the coil 12 of V phase and the diode D22 in this order, thereafter flowing into the smoothing capacitor 1. Thus, electric charges are accumulated in the smoothing capacitor 1 to raise the voltage Vdc across the smoothing capacitor 1 as shown in Fig. 2.

When the high arm side transistors Q22 and Q23, and the low arm side transistors Q24 and Q26 are switched from ON to OFF, the voltage Vdc across the smoothing capacitor 1 also rises.

That is, when a ground fault is generated in the three-phase motor 10, the voltage Vdc across the smoothing capacitor 1 rises each time any one of the high arm side transistors Q21 to Q23, and the low arm side transistors Q24 to Q26 is switched from ON to OFF.

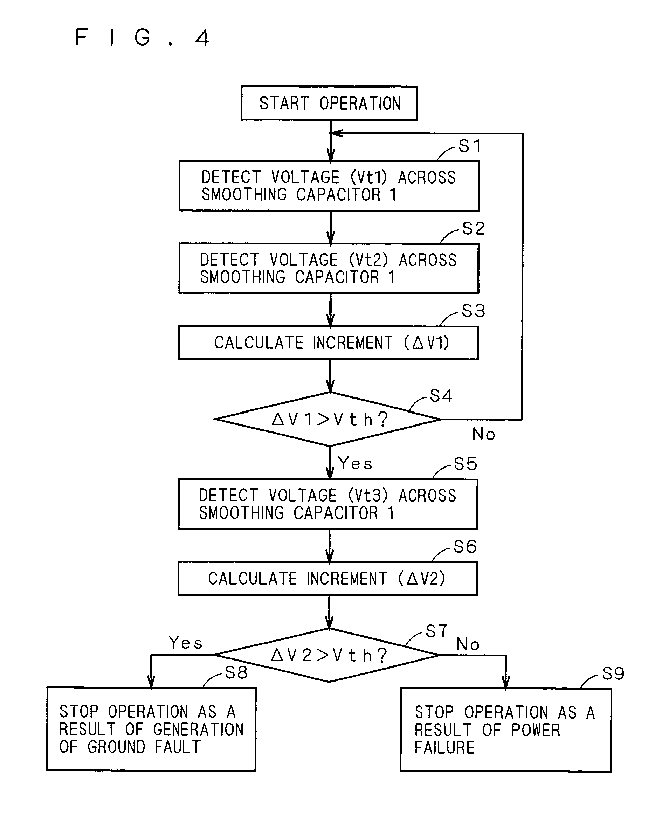

In the present embodiment, the rise of the voltage Vdc across the smoothing capacitor 1 resulting from the above-discussed operation is detected to thereby detect a ground fault generated in the three-phase motor 10. However, the rise of the voltage Vdc across the smoothing capacitor 1 results from another factor such for example as power failure other than a ground fault generated in the three-phase motor 10. In the present embodiment, a ground fault generated in the three-phase motor 10 can be detected independently of power failure as discussed below. Fig. 4 shows operations of ground fault detection of the inverter system according to the present embodiment. In the description given below, reference may be made to Fig. 2 according to circumstances, if necessary.

First, in step S1, the voltage detection part 3 detects a voltage Vt1 across the smoothing capacitor 1, and outputs the same to the control unit 50.

In step S2, after at least any one of the high arm side transistors Q21 to Q23 and the low arm side transistors Q24 to Q26 is switched from ON to OFF from the time of the execution of step 1, the voltage detection part 3 detects a voltage Vt2 across the smoothing capacitor 1, and outputs the same to the control unit 50. This is realized for example by setting the detection period of the voltage detection part 3 longer than the period of a PWM signal given from the control unit 50.

In step S3, the control unit 50 makes calculation ΔV1 = Vt2 - Vt1 where ΔV1 is an increment of the voltage across the smoothing capacitor 1.

In step S4, the control unit 50 determines whether the increment ΔV1 exceeds a predetermined certain value Vth.

When the increment ΔV1 does not exceed the certain value Vth as a result the determination in step S4, the process is restarted from step S 1.

When the increment ΔV1 exceeds the certain value Vth as a result of the determination in step S4, after at least any one of the high arm side transistors Q21 to Q23 and the low arm side transistors Q24 to Q26 is switched from ON to OFF from the time of the execution of step S3, the voltage detection part 3 again detects a voltage Vt3 across the smoothing capacitor 1, and outputs the same to the control unit 50 in step S5.

In step S6, the control unit 50 makes calculation ΔV2 = Vt3 - Vt2 where ΔV2 is an increment of the voltage across the smoothing capacitor 1.

In step S7, the control unit 50 determines whether the increment ΔV2 exceeds the predetermined certain value Vth.

When the increment ΔV2 exceeds the predetermined certain value Vth as a result of the determination in step S7, the control unit 50 determines that a ground fault is generated in the three-phase motor 10. Then the control unit 50 turns off the switch 2 to stop the operation in step S8.

When there is no excess as a result the determination in step S7, the control unit 50 determines that power failure is generated. Then the control unit 50 turns off the switch 2 to stop the operation in step S9.

Thus, a ground fault generated in the three-phase motor 10 can be detected using the existing inverter 100. Further, the increment of the voltage across the smoothing capacitor 1 is detected twice to thereby discriminate between the rise of the voltage across the smoothing capacitor 1 caused by sudden power failure and that caused by a ground fault. A ground fault can thereby be detected independently of power failure. Thus, a location of breakdown can be easily specified after the operation is stopped to shorten a period of time required for recovery from the breakdown.

The ground fault detection method according to the present invention does not necessarily require the execution of all the steps shown in Fig. 4. As an example, when the increment ΔV1 exceeds the certain value Vth as a result of the determination in step S4, the operation may be stopped immediately. In this case, the rise of the voltage across the smoothing capacitor 1 is caused either by a ground fault generated in the three-phase motor 10 or by power failure, which cannot be easily discriminated. However, this way is applicable as long as operation is stopped to specify a location of breakdown and repair the breakdown on the occurrence of any abnormality.

While the invention has been shown and described in detail, the foregoing description is in all aspects illustrative and not restrictive. It is therefore understood that numerous modifications and variations can be devised without departing from the scope of the invention.

## Claims

1. A ground fault detection method of detecting a ground fault generated in an inductive polyphase load (10) driven by an inverter (100), the inverter comprising:
a first DC power line (VH);
a second DC power line (VL) to which a potential is applied that is lower than a potential applied to said first DC power line;
a smoothing capacitor (1) connected between said first DC power line and said second DC power line;
a plurality of output lines (L4, L5, L6) connected to said inductive polyphase load;
a plurality of high arm side switches (Q21, Q22, Q23) each connected between said first DC power line and a corresponding one of said output lines;
diodes (D21, D22, D23) each connected in parallel with a corresponding one of said high arm side switches and having cathodes connected to said first DC power line;
a plurality of low arm side switches (Q24, Q25, Q26) each connected between said second DC power line and a corresponding one of said output lines; and
diodes (D24, D25, D26) each connected in parallel with a corresponding one of said low arm side switches and having anodes connected to said second DC power line,
wherein a voltage across said smoothing capacitor rises by the switching of at least any one of said high arm side switches and said low arm side switches from ON to OFF, thereby determining that said ground fault is generated.

2. The ground fault detection method according to claim 1, executing:
(a) a step (S1) of detecting a first one of said voltage (Vt1) across said smoothing capacitor;
(b) a step (S2) of detecting a second one of said voltage (Vt2) across said smoothing capacitor after at least any one of said high arm side switches and said low arm side switches is switched from ON to OFF from the time of the execution of said step (a); and
(c) a step (S3, S4) of determining whether or not an increment (ΔV1) of said second one of said voltage relative to said first one of said voltage exceeds a first certain value.

3. The ground fault detection method according to claim 2, further executing:
(d) a step (S5) of detecting a third one of said voltage (Vt3) across said smoothing capacitor after at least any one of said high arm side switches and said low arm side switches is switched from ON to OFF from the time of the execution of said step (b); and
(e) a step (S6, S7) of determining whether or not an increment (ΔV2) of said third one of said voltage relative to said second one of said voltage exceeds a second certain value.
